# EUROPEAN PATENT APPLICATION

(11) **EP 0 644 585 A2**
(43) Date of publication of application: **22.03.1995**
(21) Application number: 94111795.4
(22) Date of filing: 28.07.1994
(51) Int. Cl.: H01L 21/48, H01L 23/495, B23H 9/00

(54) **Lead frame and method of manufacturing the same**

(30) Priority: 20.09.1993 JP 233802/93
(71) Applicant: SUMITOMO ELECTRIC INDUSTRIES, LIMITED, Osaka 541 (JP)
(72) Inventor: Hashimoto, Shogo, c/o Itami Works, Itami-shi, Hyogo (JP); Awata, Hideaki, c/o Itami Works, Itami-shi, Hyogo (JP); Ihara, Tomohiko c/o Itami Works, Itami-shi, Hyogo (JP)
(74) Representative: Eder, Thomas, Dr.-Ing.

(57) **Abstract**

Lead frames having inner leads arranged with high density are manufactured with high accuracy and at low cost. The tip portions of the inner leads are separated from one another by wire electrical discharge machining (EDM) to the pitch at tip of 0.165 mm to 0.200 mm and the width of not less than 0.09 mm.

## Description

This invention relates to a lead frame used on a package for mounting an integrated circuit chip and a method of manufacturing the same.

A package for mounting an integrated circuit chip or integrated semiconductor chip has a lead frame used to electrically connect the chip through bonding wires. Such a lead frame is made up of a plurality of metallic conductor strips that extend radially toward the semiconductor chip mounting portion of the package. Each conductor strip has an inner lead having a tip to which a bonding wire is connected, and an outer lead continued to the inner lead and protruding from the package.

Conventional lead frames are usually formed by stamping with a press. Such stamping requires an expensive die. Moreover, it is difficult to form a lead frame having a large number of inner leads with high dimensional accuracy by stamping, because it is difficult to form a die having a complicated shape with high accuracy.

It is also known to form a lead frame by photo-etching. Photo-etching needs no expensive tools and has wider use, but has a problem in that the forming process is complicated and thus the manufacturing cost is high.

Either of these methods has another problem in that it is impossible to reduce the distance between the tips of the adjacent inner leads to below 90% of the thickness of the metal conductors. For example, on a mass-production basis, it is impossible to reduce the distance below 0.113 - 0.115 mm if the thickness of the metal conductors is 0.125 mm. If a 0.125-mm-thick lead frame has inner leads each having a width of 0.115 mm and spaced apart a distance of 0.115 mm from each other at their tips, the pitch of the leads at the tips will be 0.230 mm. Taking also into consideration the size of the semiconductor chip and the length of the bonding wires, it will be impossible to form a lead frame having more than 260 inner leads by photo-etching or stamping.

If more than 260 inner leads are needed, one has to use a more costly package such as a pin-grid array or other bonding method such as tape automated bonding (TAB). But the pin-grid array package has a shortcoming in that the newest surface mounting technique (SMT) cannot be used. TAB tends to be costly if the production lot is small. It also requires highly skilled hands in handling and assembling.

In another known method, inner leads are first formed by etching or stamping with their tips still connected together. Then, the tips are cut apart from one another using a CO₂ laser or a YAG laser. Trials have been made so that the inner leads thus formed have a sufficiently small tip-to-tip distance of 0.080 mm. But this method has its own shortcomings. Namely, in order to prevent the metal produced by melting the metal conductor with the laser from sticking to the material being worked, a gas such as nitrogen gas has to be sprayed in large amounts to the portion being worked. This leads to an increase in the production cost. Moreover, even by spraying such a large amount of gas, it is impossible to completely prevent the molten metal from sticking to the material. Also, the surfaces cut by the lasers tend to be rough.

Another problem of forming the inner leads by etching is that their tips tend to have a trapezoidal section whose upper side, to which bonding wires are to be connected, is longer than the lower side. The smaller the pitch of the inner leads at their tips, the more pronounced this tendency becomes. If bonding wires are connected to such tips, the tips are more likely to be twisted. This increases the possibility of poor connection.

An object of this invention is to provide a lead frame which can be manufactured at low cost and which has inner leads provided at high density and with high accuracy and a method of manufacturing such a lead frame.

The lead frame according to this invention is provided on a package for mounting an integrated circuit chip, the lead frame comprising a plurality of metal conductors having a thickness of 0.10 mm to 0.25 mm and radially extending toward a portion for mounting the integrated circuit chip, characterized in that: the metal conductors have inner leads having inner tip portions to which bonding wires are connected, the inner tip portions being separated from one another by wire electrical discharge machining so that the pitch will be 0.165 mm to 0.200 mm at their extreme inner ends and the width will be not less than 0.09 mm at their extreme inner ends.

There is also provided a method of manufacturing a lead frame for use on a package for mounting an integrated circuit chip, the lead frame comprising a plurality of metal conductors having a thickness of 0.10 mm to 0.25 mm and radially extending toward a portion for mounting the integrated circuit chip, characterized in that: the method comprising the steps of forming inner leads of the metal conductors by etching or stamping with inner tip portions of the inner leads integral with one another, and separating the inner tip portions by wire electrical discharge machining so that the pitch will be 0.165 mm to 0.200 mm at their extreme inner ends and the width will be not less than 0.09 mm at their extreme inner ends.

According to this invention, the tips of the inner leads are separated from each other by wire-EDM, so that the tips can be arranged at a pitch of 0.165 mm to 0.200 mm at their extreme inner ends while maintaining their width at not less than 0.09 mm. Thus, the inner leads can be arranged at very high density. Also, wire-EDM can produce smooth cut surfaces and form tips having a substantially rectangular section instead of a trapezoidal section. This makes it possible to prevent the tips from being twisted when connecting bonding wires and thus prevent poor electrical connection. Furthermore, since the tips of the inner leads are separated by inexpensive wire-EDM, inner leads can be produced efficiently and at low cost.

Other features and objects of the present invention will become apparent from the following description made with reference to the accompanying drawings, in which:
Fig. 1A is a plan view of a portion of one embodiment of the lead frame according to this invention;
Fig. 1B is an enlarged perspective view of the same;
Fig. 2 is a plan view of the same showing the state as connected to a semiconductor chip;
Fig. 3A is a plan view of a portion of the lead frame showing its manufacturing process; and
Fig. 3B is an enlarged perspective view of the same showing another manufacturing process.

Now we will describe the embodiments of this invention with reference to the accompanying drawings.

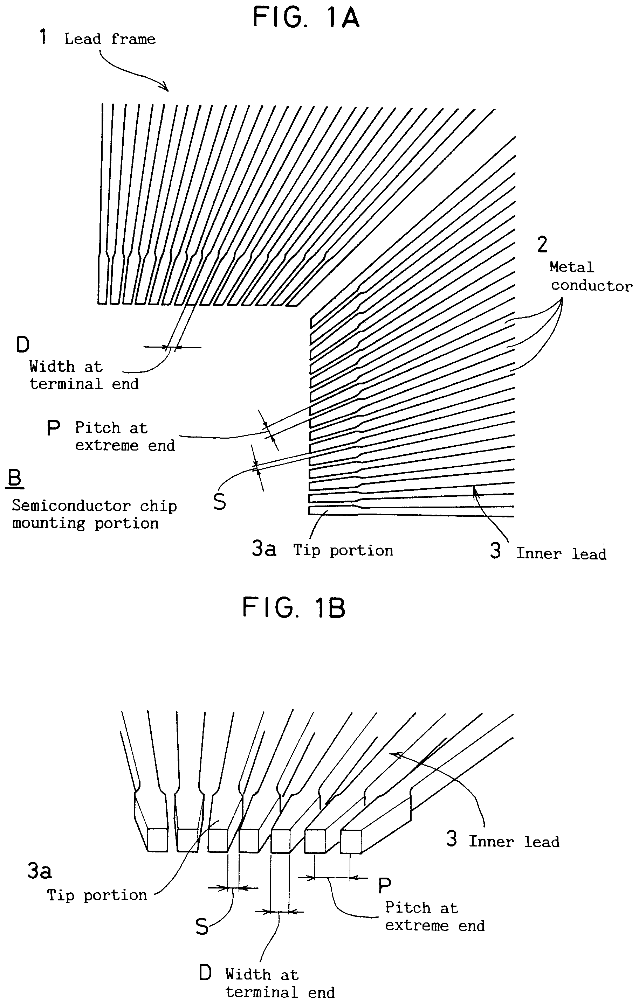

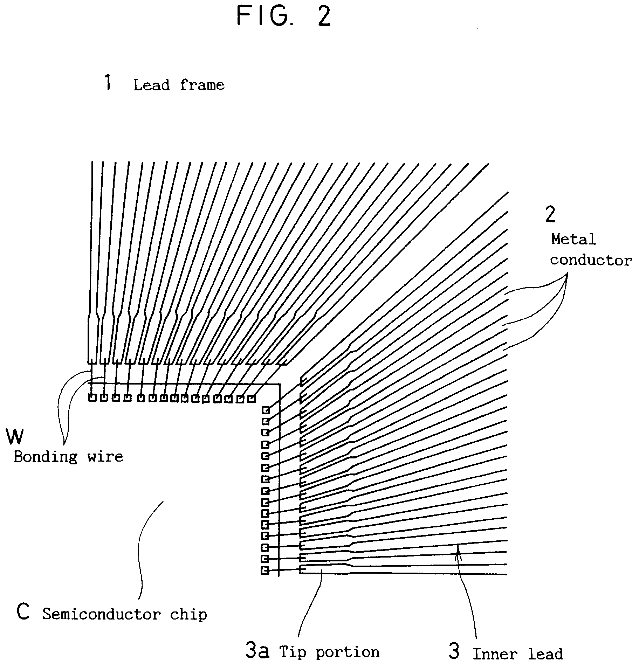

Figs. 1A and 1B show one embodiment of a lead frame 1 according to this invention. Fig. 2 is a plan view of a portion of the same connected to an integrated semiconductor chip C. The lead frame 1 is provided on a package for mounting the semiconductor chip C. It comprises a plurality of metal conductors 2 each having a thickness of 0.10 mm to 0.25 mm and extending from all the directions toward a semiconductor chip mounting portion B at the center of the package. The lead frame 1 is covered with a resin or ceramics material and has inner leads 3 connected at their tips 3a to respective bonding wires W, and outer leads (not shown) continued to the respective inner leads 3 and exposed from the package. The metal conductor is preferably made of an iron-nickel alloy or a copper alloy.

The tip portions 3a (the portions about 0.8 mm long from the inner ends of the leads) of the inner leads 3 are arranged at a pitch P of 0.165 mm to 0.200 mm at their extreme ends and have a width D of 0.09 mm or more at their terminal ends. The width D has to be at least 0.09 mm for wire bonding work.

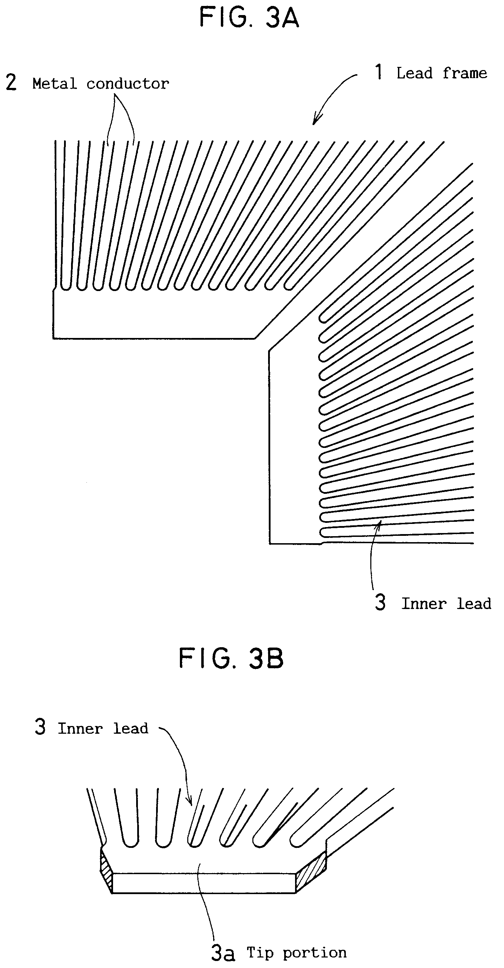

The lead frame 1 (including the inner leads 3) is first formed by etching or punching, with their tip portions 3a still connected together (see Figs. 3A and 3B). Then, the tip portions 3a are separated from one another by wire electrical discharge machining (EDM) using a wire having a diameter of 75 µm or less.

Since the tip portions 3a of the inner leads 3 are separated by wire-EDM, the distance S between the adjacent tips 3a can be made smaller than when forming such tips by etching or punching. More specifically, if a 50- µm-diameter wire is used in the wire-EDM, the tip-to-tip distance S of the inner leads 3 will be 65 µm. This makes it possible to arrange the tips 3a of the inner leads 3 at a pitch P of 0.165 mm to 0.200 mm while keeping their width D of not less than 0.09 mm.

Thus, the inner leads 3 can be arranged at higher density than those formed by etching or punching. The tips 3a of the inner leads 3 thus formed have a simple rectangular cross-section with high accuracy, so that they are less likely to be twisted when connecting bonding wires W to the tips 3a of the inner leads 3. Thus, there is no possibility of bad electrical connection. Also, smooth cut surfaces are obtainable, which was impossible by melting with a laser. Also, since the wire-EDM is an inexpensive method and only the tips 3a of the inner leads 3 are worked, the tips can be formed in a short time. Thus, the lead frame 1 can be produced efficiently and at low cost.

A plurality of stacked lead frames 1 should be subjected to wire-EDM at a time for higher machining efficiency.

When subjecting the lead frame to etching before wire-EMD, the inner leads 3 are connected together at their tips 3a, so that the strength at the tips 3a is high. Thus, the yield during etching is sufficiently high.

## Claims

1. A lead frame for use on a package for mounting an integrated circuit chip, said lead frame comprising a plurality of metal conductors having a thickness of 0.10 mm to 0.25 mm and radially extending toward a portion for mounting the integrated circuit chip, characterized in that:
said metal conductors have inner leads having inner tip portions to which bonding wires are connected, said inner tip portions being separated from one another by wire electrical discharge machining so that the pitch will be 0.165 mm to 0.200 mm at their extreme inner ends and the width will be not less than 0.09 mm at their extreme inner ends.

2. A method of manufacturing a lead frame for use on a package for mounting an integrated circuit chip, said lead frame comprising a plurality of metal conductors having a thickness of 0.10 mm to 0.25 mm and radially extending toward a portion for mounting the integrated circuit chip, characterized in that:
said method comprising the steps of forming inner leads of said metal conductors by etching or stamping with inner tip portions of said inner leads continued to one another, and separating said inner tip portions by wire electrical discharge machining so that the pitch will be 0.165 mm to 0.200 mm at their extreme inner ends and the width will be not less than 0.09 mm at their extreme inner ends.
